# EUROPEAN PATENT SPECIFICATION

(11) **EP 4 583 406 B1**
(45) Date of publication and mention of the grant of the patent: **09.09.2026**
(21) Application number: 24220736.3
(22) Date of filing: 17.12.2024
(51) Int. Cl.: H03K 19/1776, H03K 19/17772

(54) **CONFIGURABLE MULTILAYERED OVERRIDE SYSTEM AND METHOD FOR CIRCUMVENTING SEMICONDUCTOR CIRCUITRY WITH UNPREDICTABLE SILICON BEHAVIOR**
KONFIGURIERBARES MEHRSCHICHTIGES ÜBERSTEUERUNGSSYSTEM UND VERFAHREN ZUR UMGEHUNG VON HALBLEITERSCHALTUNGEN MIT UNVORHERSEHBAREM SILICIUMVERHALTEN
SYSTÈME ET PROCÉDÉ DE NEUTRALISATION MULTICOUCHE CONFIGURABLE POUR CONTOURNER UN CIRCUIT À SEMI-CONDUCTEURS AVEC UN COMPORTEMENT DE SILICIUM NON PRÉVISIBLE

(30) Priority: 28.12.2023 IN 202341089271
(43) Date of publication of application: 09.07.2025
(73) Proprietor: NXP B.V., 5656 AG Eindhoven (NL)
(72) Inventor: Srivastava, Neha, 5656AG Eindhoven (NL); Tikoo, Gautam, 5656AG Eindhoven (NL); Pandey, Rakesh, 5656AG Eindhoven (NL)
(74) Representative: Schwarzweller, Thomas

(56) References cited:
- US-B1- 7 030 646
- US-B1- 7 177 221
- US-B2- 7 282 949

## Description

### BACKGROUND

### FIELD

The present disclosure relates in general to semiconductor debugging, and more particularly to a configurable multilayered override system and method for circumventing semiconductor circuitry with unpredictable silicon behavior.

### DESCRIPTION OF THE RELATED ART

Across the semiconductor industry, expensive device recalls, re-spins, or the need for immediate tape-out are commonly performed to repair errors and bugs arising due to uncertainties caused by unpredictable silicon behavior of analog circuits, security logic, device phantom modes, reset behavior, state machine switches, etc. Unpredictable silicon behavior occurs more frequently with new technology development, with new architectures, or when transitioning existing designs to new technology nodes. These uncertainties have a substantial impact on cost and overall development time. In this manner, when a fresh revision or a full tape-out is planned due to any such uncertainty, without going through a full validation cycle, such activities have a substantial negative impact.

A possible oversight on any one of these complex, critical, interdependent infrastructural modules can lead to a device hang-up or misbehavior which ends up impacting the entire device functionality (e.g. device boot) and blocks development of customer application for working logic, eventually leading to expensive, back-to-back re-spins. Additionally, many of such silicon behaviors are not easy to predict during pre-silicon verification before handing off device to validation or, ultimately, the customer. For such devices, there is always a need to have fallback logic which may compromise or even bypass new design features (e.g., security, safety, functional availability etc.), but will ensure a higher confidence for silicon bring-up.

The conventional approach to have such fallback logic is through blanket override schemes with hard configuration (e.g., hardware metal plug) at tape-out, as the chip cannot be guaranteed to be configured via software or debugger in a stuck-in-reset kind of situation on silicon. However, such an implementation often delays fully functional samples from being shipped to customer as well as a compulsory tape-out to fix the hard configuration.

There are many limitations to the conventional approach. The hard configurations were not reversible nor revokable and the device could not be tested or validated by temporarily removing these hard configurations. In the case of a design with multiple hard configurations, the selection of hard configurations (keeping some and removing others) was not possible without subsequent tape-outs or at least impractical or too expensive. The validation of such silicon can only be performed with a particular hardware configuration for one tape-out at a time rather than a complete validation of all possible hardware combinations of the device. There was no notion of application of such hard overrides at a delayed time after reset to take care of overrides that might be required only for particular states or windows of the design execution and not at all times. In the absence of any option to revoke the hard configurations, or if such hard configurations misbehaved, the device could not be given as a fully functional sample to the post-silicon team or even to customers for any software development or the like.

The document US7177221 B1 discloses a circuit for overriding a configuration bit during start or power up of a semiconductor device through a fixed metal connection during power up.

### SUMMARY

According to a first aspect of the present disclosure, there is provided an override circuit for a semiconductor chip, comprising: an override interface that intercepts an original value provided from a provider block to a consumer block, wherein the override interface is configured to select between the original value and a selected override value for providing an output value to the consumer block; a timer that provides a timeout signal after a predetermined time period after a start-up time of the semiconductor chip; and a priority override controller having a default configuration for controlling the override interface to select the original value as the output value at the start-up time until the timeout signal is provided, and then to control the override interface to select a fixed metal hardware override value as the selected override value provided as the output value; wherein the priority override controller is configurable to control the override interface to instead select the selected override value at start-up and to select at least one configurable override value as the selected override value.

In one or more embodiments, the override interface comprises a multiplexer having a first input receiving the original value, a second input receiving the selected override value, a select input receiving an output select signal from the priority override controller, and an output for providing the output value. The timer may comprise a counter programmed with a count value indicative of a maximum time period. The fixed metal hardware override value may comprise a least one metal plug provided on a metal layer of the semiconductor chip.

In one or more embodiments, the priority override controller comprises: override select logic that selects between the fixed metal hardware override value and the at least one configurable override value as the selected override value based on an override select signal; and a priority output selector having at least one first input for receiving at least one configurable select value, having a second input receiving an overtime signal indicative of the timeout signal, having a first output providing the override select signal and having a second output providing an output select signal for controlling the override interface.

In one or more embodiments, the priority output selector has a default configuration when each of the at least one configurable select value has an initial non-select value for providing the override select signal so that the override select logic selects the fixed metal hardware override value as the selected override value, and for controlling the override interface to select the original value as the output value at the start-up time until the overtime signal is provided, and then to select the selected override value as the output value after the overtime signal is provided.

The override circuit may further comprise a Boolean logic AND gate having a first input receiving the timeout signal, having a second input receiving a hardware fixed metal plug value, and having an output providing the overtime signal. The priority output selector has an override input receiving a hardware fixed metal plug value that causes the priority output selector to control the override interface to select the original value as the output value at start-up regardless of the at least one first input and the second input.

In one or more embodiments, the override select logic comprises a multiplexer having a first input receiving a hardware override fuse value, a second input receiving a software override value, a third input receiving the fixed metal hardware override value, a select input receiving the override select signal, and an output providing the selected override value; and the priority output selector has a first input receiving a hardware override select value for selecting the hardware override fuse value as the selected override value when the hardware override select value is provided, a second input receiving a software override select value for selecting the software override value as the selected override value when the software override select value is provided, and a third input receiving the overtime signal for selecting the fixed metal hardware override value as the selected override value when the overtime signal is provided.

In one or more embodiments, when the hardware override select value is provided, the priority output selector controls the override select logic to select the hardware override fuse value as the selected override value, wherein when the hardware override select value is not provided and the software override select value is provided, the priority output selector controls the override select logic to select the software override value as the selected override value, and wherein the priority output selector otherwise controls the override select logic to select the fixed metal hardware override value as the selected override value when the overtime signal is provided.

According to a second aspect of the present disclosure, there is provided a method of circumventing semiconductor circuitry on an integrated circuit with unpredictable silicon behavior, comprising: providing an override interface between a provider block and a consumer block for selecting between the original value provided by the provider block and a selected override value as an output value provided to the consumer block; providing a timeout signal after a predetermined time period after a first start-up of the semiconductor circuitry; initially controlling the override interface upon the first start-up to select the original value as the output value until the timeout signal is provided, and then to select a fixed metal hardware override value as the selected override value as the output value; and when the original value is not provided before the timeout signal is provided after the first start-up, subsequently controlling the override interface to instead select the selected override value upon subsequent start-ups of the semiconductor circuitry and selecting at least one configurable override value as the selected override value.

The method may further comprise programming the fixed metal hardware override value on a metal layer of the integrated circuit. It may further comprise programming a fixed metal plug that modifies operation of the override interface to always select the original value upon subsequent start-ups. It may further comprise: programming a software override value; and the selecting at least one configurable override value may comprise selecting the software override value as the selected override value provided to the receive circuitry upon subsequent start-ups. It may further comprise executing diagnostic software to identify solutions to correct behavior of the semiconductor circuitry. It may yet further comprise: programming a hardware override fuse value; and the selecting at least one configurable override value may comprise selecting the hardware override fuse value as the selected override value provided to the receive circuitry upon subsequent start-ups.

According to a third aspect of the present disclosure, there is provided a semiconductor chip, comprising: a plurality of provider blocks each configured to provide a corresponding one of a plurality of original values; a plurality of consumer blocks each configured to receive a corresponding one of a plurality of original values; and a plurality of override circuits, each interposed between one of the plurality of provider blocks and a corresponding one of the plurality of consumer blocks, each of the plurality of override circuits comprising: an override interface that intercepts one of the plurality of original values provided from a corresponding one of the plurality of provider blocks to a corresponding one of the plurality of consumer blocks, wherein the override interface is configured to select between the corresponding original value and a selected override value for providing an output value to the corresponding consumer block; a counter that provides a timeout signal after a predetermined time period after a start-up time of the semiconductor chip; and a priority override controller having a default configuration for controlling the override interface to select the corresponding original value as the output value at the start-up time until the timeout signal is provided, and then to control the override interface to select a fixed metal hardware override value as the selected override value provided as the output value; wherein the priority override controller is configurable to control the override interface to instead select the selected override value at start-up and to select at least one configurable override value as the selected override value.

In one or more embodiments, the fixed metal hardware override value comprises a least one metal plug provided on a metal layer of the semiconductor chip. In one or more embodiments, the priority override controller is reconfigured to control the override interface to select the selected override value at start-up and to select a software override value as the selected override value. In one or more embodiments, the priority override controller is reconfigured to control the override interface to select the selected override value at start-up and to select a hardware override fuse value as the selected override value.

### BRIEF DESCRIPTION OF THE DRAWINGS

Embodiments of the present invention are illustrated by way of example and are not limited by the accompanying figures. Similar references in the figures may indicate similar elements. Elements in the figures are illustrated for simplicity and clarity and have not necessarily been drawn to scale.
FIG. 1 is a simplified block diagram of fuse, clock, and reset (FCR) circuitry integrated onto a semiconductor chip incorporating override circuits implemented according to one embodiment.
FIG. 2 is a simplified block diagram of an override circuit that may be used as either one or both of the override circuits of FIG. 1 according to one embodiment.
FIG. 3 is a simplified block diagram of an override circuit that may be used as either one or both of the override circuits of FIG. 1 according to a more specific embodiment.
FIG. 4 is a tabular diagram listing the input values OT, HW OVR select, SW OVR select, and HW FMP and the corresponding values OSEL and OUT for the override circuit of FIG. 3 according to one embodiment.
FIG. 5 is a simplified block diagram illustrating distribution of override circuits (OVR) across the semiconductor chip of FIG. 1 inserted between pairs of provider (PR) blocks and consumer (CN) blocks according to one embodiment.
FIG. 6 is a flowchart diagram illustrating an override system and method according to one embodiment.

### DETAILED DESCRIPTION

A multilayered, self-correcting and revokable override system supporting independent enablement or disablement of hard configurations encapsulated as a reusable override circuit to provide device optionalism around critical but uncertain logic, such as analog circuitry, reset state machines and handshakes, security protections, debug connections, device phantom modes, etc. A multilayered and configurable override circuit is provided as a combination of hardware programmable states (e.g., fuse words), hardware fixed states (e.g., metal plugs) and software programmable configurations with options to selectively and independently revoke or apply each layer. The override circuit is also intelligent and design-state-aware while enabling or revoking the overrides.

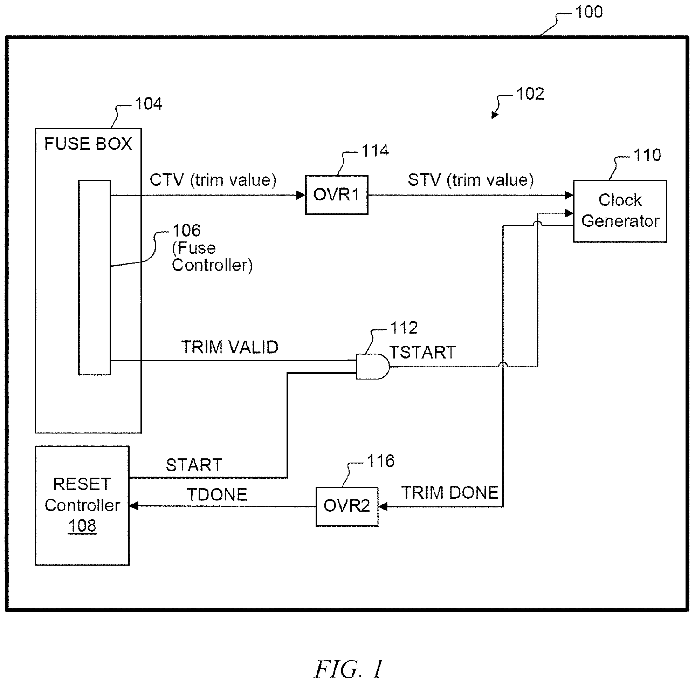

FIG. 1 is a simplified block diagram of fuse, clock, and reset (FCR) circuitry 102 integrated onto a semiconductor chip 100 incorporating override circuits implemented according to one embodiment. The FCR circuitry 102 includes a fuse box 104, a fuse controller 106, a reset controller 108, a clock generator 110, and a 2-input Boolean logic AND gate 112. A first override circuit OVR1 114 is provided between the fuse controller 106 and the clock generator 110 and a second override circuit OVR2 116 is provided between the clock generator 110 and the reset controller 108. The FCR circuitry 102 includes timing and verification logic operating as a handshake function for indicating the validity of fuse values retrieved from the fuse box 104. Typical timing and verification logic may include, for example, error correction code (ECC) check circuitry, disable circuitry, valid circuitry, etc., that indicates whether a fuse value is valid. Such timing and verification logic is simplified and represented by the AND gate 112.

The fuse box 104 is a non-volatile memory, such as a Flash memory or the like, that stores multiple programmable values that may be use as adjustment or trim values or the like for various circuitry provided on the chip 100. In the illustrated configuration, for example, the clock generator 110 may be configured to operate at an initial operating frequency upon power-on or reset (POR), and to adjust its operating frequency after POR based on a trim value retrieved from the fuse box 104 as further described herein.

The reset controller 108 is responsible for initializing and monitoring various critical circuitry functions for ensuring a successful start-up of the chip 100. In one embodiment, the reset controller 108 monitors the state of the power supply (not shown) including supply voltages and the like, and then monitors the state of internal oscillators and other clock functions including, for example, the clock generator 110. In general, the steps through sequential states while verifying operation of circuitry of the chip 100, including the clock generator 110, and ultimately hands control over to primary processing circuity (not shown) for performing the primary functions of the chip 100.

In one embodiment, the reset controller 108 detects that the clock generator 110 needs a trim value from the fuse box 104. The reset controller 108 prompts the fuse controller 106 to access and provide a trim value for the clock generator 110 and asserts a START signal. The fuse controller 104 accesses the trim value and provides the value as a clock trim value (CTV) for use by the clock generator 110. In a conventional configuration, OVR1 114 is not included so that CTV would be provided directly to the clock generator 110. The fuse controller 106 also provides a handshake signal TRIM VALID when CTV is provided and valid. The AND gate 112 asserts a corresponding start signal TSTART to the clock generator 110 indicating that the retrieved value is provided and valid. Assuming correct operation, the clock generator 110 receives and reprograms an internal oscillator or the like to adjust its operating frequency. Assuming the clock generator 110 correctly receives CTV and adjusts operation accordingly, it provides another handshake signal TRIM DONE to the reset controller 108. Again, in a conventional configuration, OVR2 116 is not included so that TRIM DONE would be provided directly to the reset controller 108, and upon receiving the TRIM DONE signal, the reset controller 108 may resume reset operations.

The adjustment and handshake operation described for the FCR circuitry 102 may fail because of unpredictable silicon behavior. As an example, although the FCR circuitry 102 may operate correctly when integrated on a prior semiconductor chip implemented using a prior technology node, such as 16 nanometer (nm), when the FCR circuitry 102 is migrated onto the semiconductor chip 100 implemented according to a new technology node, such as 5nm, new errors and bugs may arise causing failure of operation. Timing parameters on the first technology node may be sufficiently different resulting in timing bugs and errors. Suppose, for example, that the fuse box 104 fails such that the CTV trim value is either not provided or is provided as an incorrect value. Such errors may cause the chip 100 to simply hang-up in which it fails to come out of reset. Even if the CTV is retrieved by the clock generator 110, the clock generator 110 itself may have bugs or errors such that it does not provide the TRIM DONE signal when expected by the reset controller 108. Again, such errors may cause the chip 100 to simply hang-up in which it fails to come out of reset.

Without provisional steps that could have been taken beforehand to anticipate such errors, it is very time-consuming and expensive for engineers to debug the chip 100 in order to identify and locate all such bugs and errors in the entire circuitry of a given design. The FCR circuitry 102 is simplified and demonstrates only a couple of handshake issues, whereas a typical semiconductor chip may have a multitude (e.g., thousands upon thousands) of such handshake interfaces in which uncertainty issues may arise multiplying the time and resources consumed by a diagnostic process. In addition, even when errors and bugs are identified, the chip 100 may require one or more tape-out process iterations before it can be provided to a customer.

The override circuits OVR1 114 and OVR2 116 are provided to prevent the chip 100 from experiencing hang-up and to enable diagnostics to identify and resolve the errors and bugs. As shown, OVR1 114 is inserted in the trim value path having an input receiving CTV from the fuse box 104 and having an output providing a selected trim value STV to the clock generator 110. Also. OVR2 116 is inserted in the DONE signal path having an input receiving TRIM DONE from the clock generator 110 and an output providing a done signal TDONE to the reset controller 108. As further described herein, in the event that the fuse box 104, the fuse controller 106 and the clock generator 110 are operating correctly, then OVR1 114 simply forwards CTV as STV and OVR2 116 simply forwards TRIM DONE as TDONE to allow successful operation. In the event that any one or more of the fuse box 104, the fuse controller 106 and the clock generator 110 are not operating correctly, then the override circuits OVR1 114 and OVR2 116 incorporate timing and bypass circuitry that replaces the default values with programmable override values that prevent the chip 100 from hanging up indefinitely. Debug software may be executed by the chip 100 or by the system as a whole for identifying potential bugs or errors in order to replace default values with override values to achieve proper operation as further described herein.

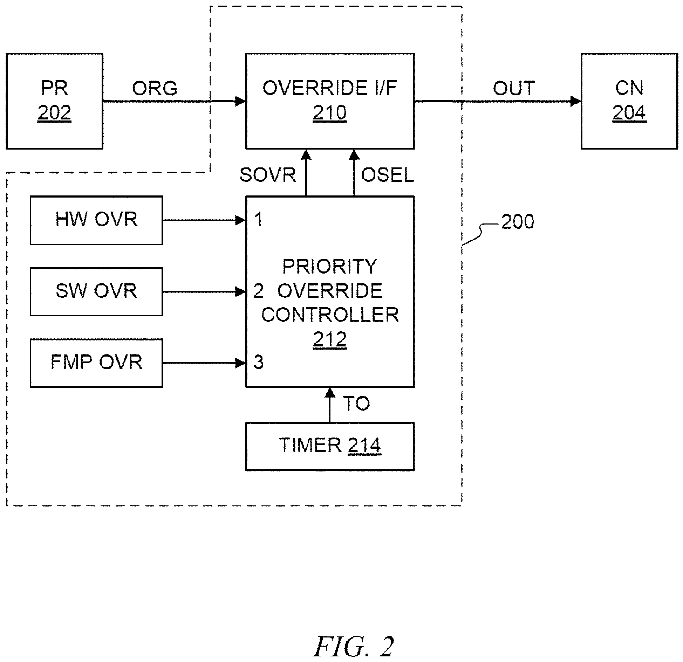

FIG. 2 is a simplified block diagram of an override circuit 200 that may be used as either one or both of the override circuits OVR1 114 and OVR2 116 according to one embodiment. The override circuit 200 is shown as an interface between a provider (PR) block 202 and a consumer (CN) block 204. The term "provider" as used in this context generally means any block, module, or circuitry or the like that generates, outputs, provides, or produces a value or the like that is intended to be received and used by another block or module. The term "consumer" as used in this context generally means any block, module, or circuitry or the like that is intended or otherwise configured to receive and use a value or the like provided from a PR block. The PR block 202 represents any module or circuitry that provides an original (ORG) value intended to be provided to the CN block 204. The term "original" as used in this context simply means the value that was originally intended to be conveyed via an interface between blocks or modules. The term "value" may represent a single handshake signal or value or a multibit signal or value or a digital value or the like with multiple signals or bits. Examples of PR blocks include the fuse box 104 or the fuse controller 106, the clock generator 110, or any other analog or digital circuitry or logic or the like. Examples of CN blocks include the clock generator 110, the reset controller 108, or any other analog or digital circuitry or logic or the like. With reference back to FIG. 1, the PR block 202 may represent the fuse controller 106 providing a trim value to the clock generator 110, which is represented by the CN bock 204. In this case, the override circuit 200 operates as OVR1 114. Similarly, the PR block 202 may represent the clock generator 110 providing the TRIM DONE signal to the reset controller 108, which in this case is represented by the CN bock 204. In this case, the override circuit 200 operates as OVR2 116. The override circuit 200 is configured according to the form of the normal value intended to be conveyed.

The override circuit 200 includes an override interface (I/F) 210 having a first input receiving the ORG value, a second input receiving a selected override (SOVR) value, a third input receiving an output select (OSEL) signal, and an output providing a selected output value OUT to an input of the CN block 204. The override I/F 210 is controlled by a priority override controller 212, which provides the SOVR value and controls the OSEL signal. The priority override controller 212 receives a configurable hardware (HW) override value HW OVR, a configurable software (SW) override value SW OVR, and a fixed metal plug (FMP) override value FMP OVR. The priority override controller 212 also receives a timeout (TO) signal from a timer 214. The priority override controller 212 prioritizes the override inputs in which HW OVR has the highest priority level (1), SW OVR has the next highest priority level (2), and FMP OVR has the lowest priority level (3). The priority override controller 212 is configured to select one of the HW OVR, SW OVR, and FMP OVR values as the SOVR value provided to the override I/F 210, and to assert OSEL to select between the ORG and SOVR values as the OUT value.

The priority override controller 212 is configurable but has a default or initial configuration. In the default configuration, upon POR (or start-up) of the chip 100, the priority override controller 212 asserts OSEL to select ORG as the OUT value provided to the CN block 204. Upon start-up the timer 214 begins timing a maximum time period as may be predetermined for the particular configuration. If the PR block 202 successfully provides a valid ORG value as OUT to the CN block 204 before TO is asserted by the timer 214, then normal operation is achieved and the override circuit 200 may remain unmodified. This does not assume proper operation of the CN block 204, but at least it may be subsequently determined by diagnostic software or the like that the PR block 202 is functioning properly. Eventually, diagnostic software executed by the chip 100 determines that the PR block 202 is correctly operating such that the override circuit 200 can remain unmodified.

If the priority override controller 212 is not otherwise programmed to select either the HW OVR or SW OVR values before TO, then it uses the FMP OVR value as the SOVR value. After initial start-up of the chip 100, if the PR block 202 does not provide a valid ORG value as OUT to the CN block 204 before TO is asserted by the timer 214, then when TO is asserted, the priority override controller 212 switches OSEL to select SOVR as the output value and provides the FMP OVR override value as the SOVR value. It is noted that the override circuit 200 may provide FMP OVR after TO is asserted even during successful operation, but the override value FMP OVR is ignored by the CN block 204 since it already received a valid ORG value. Although the predetermined time period programmed into the timer 214 is intended to be a rather large time period, at least the override circuit 200 eventually provides an override value to the CN block 204 so that the chip 100 does not freeze up or remain suspended indefinitely. It is also noted that the ORG value provided as OUT may be an invalid value, which is provided to the CN block 204 but may cause improper operation of the CN block 204. As an example, the CN block 204 may be the clock generator 110 that generates a clock signal with an incorrect frequency based on an incorrect trim value. This situation may be identified and resolved by the diagnostic software.

The diagnostic software is eventually executed and is able to determine that the ORG value was either provided correctly, not provided by the PR block 202 at all, or was otherwise provided as an incorrect or invalid value. The diagnostic software also determines whether OUT was provided as ORG or as the FMP OVR value after timeout of the timer 214. The diagnostic software also evaluates the function of the CN block 204 and determines whether or not operation is correct. For example, if CN block 204 is the clock generator 110 or other clock circuitry, the diagnostic software may evaluate the corresponding frequency of the generated clock signal for correct operation. When diagnostic software determines that OUT was provided from FMP OVR as a result of a timer timeout, it may reprogram the priority override controller 212 to instead select SW OVR as the SOVR value and switch OSEL to select SOVR and perform further diagnostics to identify errors or bugs. SW OVR is programmable in software and may be programmed to a suitable value.

Upon subsequent POR after the priority override controller 212 is reconfigured to select SW OVR, the priority override controller 212 initially asserts OSEL to bypass the ORG value and instead select the SOVR value, in which SW OVR is selected as the SOVR value used as the OUT value provided to the CN block 204. The software programmable option is considered a temporary and revokable option that is suitable for diagnostic purposes but ultimately may not deemed suitable as a final option. It may not be desired, for example, to provide the chip 100 to a customer with a software upgrade. In addition, a software option is more susceptible to tampering. Once a good value is determined or it is otherwise determined that operation is correct with a software override, the diagnostic software may reprogram the priority override controller 212 to instead select the HW OVR override value upon POR. The HW OVR value may be a configurable hardware fuse that is programmed into the fuse box 104 assuming that the fuse box 104 is operating correctly.

Upon subsequent POR after the priority override controller 212 is reconfigured to select HW OVR, the priority override controller 212 initially asserts OSEL to bypass the ORG value and instead select the SOVR value, in which HW OVR is selected as the SOVR value used as the OUT value provided to the CN block 204. Once so programmed, the HW OVR is provided as the output override value for subsequent start-ups.

In this manner, if the ORG value is either not provided or is provided as an invalid value, the chip 100 does not hang-up indefinitely. Instead, a fixed hardware override value is provided to enable the chip 100 to exit its reset state and execute diagnostic software to evaluate the chip 100 and identify corrections. The configurable software override value enables diagnostics to be performed until a final solution may be determined. The configurable hardware override value enables a final solution to be made without requiring subsequent tape-out of the chip 100.

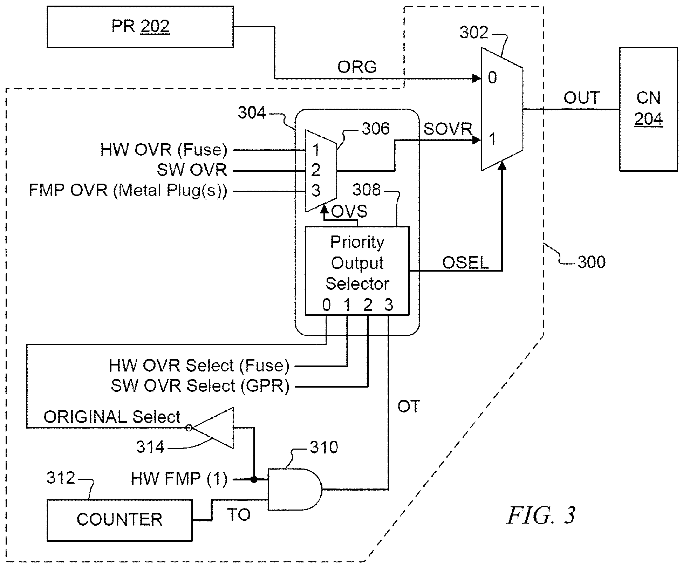

FIG. 3 is a simplified block diagram of an override circuit 300 that may be used as either one or both of the override circuits OVR1 114 and OVR2 116 according to a more specific embodiment of the override circuit 200 that may be provided as an interface between the PR block 202 and the CN block 204. The override circuit 300 includes an output multiplexer (MUX) 302 that implements the override I/F 210, a priority MUX 304, a 2-input Boolean AND gate 310, a counter 312, and an inverter 314. The priority MUX 304 includes an override MUX 306 and a priority output selector 308. The output MUX 302 has a logic 0 input receiving the ORG value, a logic 1 input receiving the selected override value SOVR, a select input receiving the output select value OSEL, and an output providing the OUT value to the CN block 204. The override MUX 306 of the priority MUX 304 has a first input (1) receiving the configurable override value HW OVR, a second input (2) receiving the configurable override value SW OVR, and a third input (3) receiving the FMP override value FMP OVR.

The priority output selector 308 has a first input with a highest priority (0) receiving an ORIGINAL select value, a second input with the next highest priority (1) receiving an HW OVR select value (used for selecting the HW OVR value), a third input with the next highest priority (2) receiving a SW OVR select value (used for selecting the SW OVR value), a fourth input with the lowest priority (3) receiving an overtime (OT) signal (used for selecting the FMP OVR value), a first output providing an override select (OVR) signal for controlling the override MUX 306, and a second output providing the OSEL signal. When each of the 0-3 inputs are logic 0, the priority output selector 308 outputs OSEL as a logic 0 so that the output MUX 302 selects ORG as OUT. When the highest priority logic 0 input is logic 1, it acts as an override so that the priority output selector 308 outputs OSEL as a logic 0 in which the output MUX 302 selects ORG as OUT.

Assuming the 0 input of the priority output selector 308 is 0, the next highest priority input asserted to logic 1 has priority so that OSEL is logic 1 and the corresponding input of the override MUX 306 is selected as the SOVR value. For example, when the HW OVR Select value is 1 so that input 1 of the priority output selector 308 is asserted to logic 1 (assuming input 0 is logic 0), then the override MUX 306 selects the HW OVR value as SOVR and sets OSEL to logic 1 so that the output MUX 302 selects SOVR (which is HW OVR) as the OUT value. Similarly, when the SW OVR Select value is 1 so that input 2 of the priority output selector 308 is asserted to logic 1 (assuming inputs 0 and 1 are both logic 0), then the override MUX 306 selects the SW OVR value as SOVR and sets OSEL to logic 1 so that the output MUX 302 selects SOVR (which is SW OVR) as the OUT value.

The HW OVR value may be provided as a fuse value, the SW OVR value may be provided from a register or the like (e.g., general purpose register or GPR), and the FMP OVR value maybe developed by one or more fixed metal plugs. Each of the HW OVR, SW OVR, FMP OVR, SOVR, and OUT values are single-bit values when the PR block 202 asserts a single value as a handshake signal or the like, such as, for example, the TRIM DONE signal shown in FIG. 1. On the other hand, when the PR block 202 asserts a multiple-bit value, such as, for example, the CTV trim value provided by the fuse controller 106, then each of the HW OVR, SW OVR, FMP OVR, SOVR, and OUT values are also multiple-bit values. The ORIGINAL select, HW OVR select, SW OVR select, and OT values are each 1-bit values.

The counter 312 implements the timer 214 and is programmed with a value for providing the TO signal after the predetermined maximum period of time. TO is provided to a first input of the AND gate 310, which has a second input receiving a hardware fixed metal plug (FMP) value, and an output providing the OT signal. HW FMP is also provided to an input of the inverter 314, having an output providing the ORIGINAL select value provided to the first input of the priority output selector 308. The HW FMP is initially programmed to have a logic 1 value.

In operation of the override circuit 300, upon POR, the counter 312 initially resets TO to 0 and begins counting, so that OT is also 0. The ORIGINAL select value is thus also 0. The HW OVR select and SW OVR select values are each initially programmed as logic 0. Thus, upon POR, each of the 0-3 inputs of the priority output selector 308 are logic 0 so that it initially asserts OSEL to 0 causing the MUX 302 to select the ORG value as the OUT value. If the ORG value is correctly provided by the PR block 202 before TO is asserted so that the CN block 204 receives ORG as OUT during a normal start-up time frame, then operation is assumed correct. In this case, the override circuit 300 need not be further modified. It is noted, however, that when the PR block 202 is deemed to be operational and if a subsequent tape-out of the chip 100 is otherwise needed, then HW FMP plug may be reprogrammed to a value 0 so that the ORIGINAL select value is 1. In this case, upon subsequent start-ups, the priority output selector 308 always provides OSEL as 0 to select the ORG value.

When TO is asserted by the counter 312, the AND gate 310 asserts OT high, which causes the priority output selector 308 to assert OSEL to 1 and to cause the override MUX 306 to select the FMP OVR value as the SOVR value provided to the logic 1 input of the output MUX 302. If the CN 204 has not already sampled a valid value from OUT by that time, then the FMP OVR value is used as the OUT value provided to the CN block 204. The diagnostic software detects that OUT was provided from FMP OVR after TO and may program the SW OVR select value to select the SW OVR value upon subsequent start-up. The software override solution using SW OVR is deemed temporary and revokable as previously described. Nonetheless, the software solution provides OUT significantly faster than FMP OVR since not based on the maximum timing function of the counter 312. Eventually, a HW OVR select fuse may be programmed to a 1 (so that the HW OVR select value is 1) so that the priority output selector 308 selects the HW OVR value as the SOVR value and also the OUT value for subsequent start-ups. This hardware override solution using the HW OVR value may be a permanent solution for the life of the chip 100.

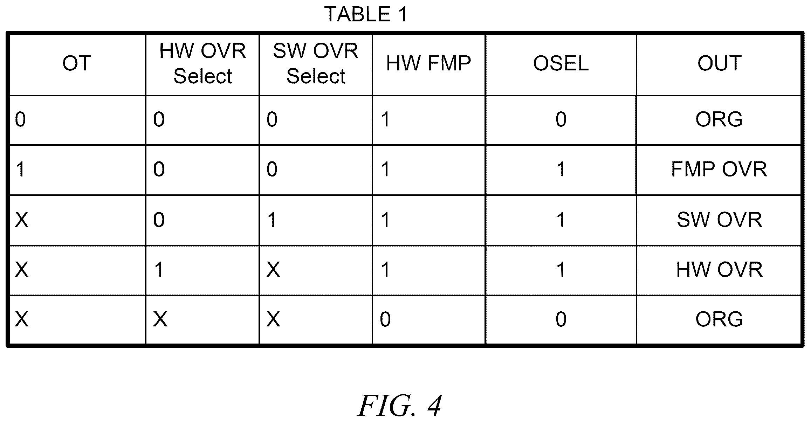

FIG. 4 is a tabular diagram (Table 1) listing the input values OT, HW OVR select, SW OVR select, and HW FMP and the corresponding values OSEL and OUT for the override circuit 300 of FIG. 3 according to one embodiment. The first row illustrates the initial configuration of the override circuit 300 that applies upon first POR of the chip 100. The HW FMP value, which may be implemented a hardware metal plug, is programmed or otherwise configured as a logic 1. The HW OVR select value is provided by a hardware fuse that is programmed as a logic 0. The SW OVR select value may be provided by a register (e.g., GPR) or the like that is programmed as a logic 0. Upon POR, the counter 312 is reset and TO is 0 so that OT is initially 0. Thus, the 0-3 inputs of the priority output selector 308 are all logic 0's so that OSEL is provided as logic 0 to select the ORG value from the PR block 202.

If the ORG value is successfully provided as the OUT value to the CN block 204 before timeout (e.g., assertion of TO), and diagnostic software subsequently determines proper operation of the CN block 204, then the override circuit 300 may remain unmodified. In this case, the override circuit 300 selects ORG as OUT for each subsequent POR as indicated in the first row of Table 1. At this time it is noted that HW FMP may be changed to a logic 0 as shown in the fifth or last row of Table 1. If so, then the ORIGINAL select value is logic 1 which controls the priority output selector 308 to always output OSEL = 0 to select the ORG value for subsequent start-ups. It is noted, however, that the HW FMP is a hardware plug so that changing its value may require a new metal layer tape-out which is otherwise not an optimal solution. In the event a tape-out may of the metal layer may be required for other reasons, then HW FMP may be reprogrammed to logic 0 so that the override circuit 300 is effectively hardwired to select ORG as the OUT value.

If the ORG value is not successfully provided and the counter 312 overflows after expiration of the maximum time period, the state of the override circuit 300 is shown in the second row of Table 1. The priority output selector 308 toggles OSEL to logic 1 and controls the override MUX 306 to select the FMP OVR value as the SOVR value, so that the output MUX 302 selects SOVR = FMP OVR as the OUT value provided to the CN block 204. Diagnostic software subsequently detects that OUT provided to the CN block 204 was caused by overflow of the counter 312 resulting in the FMP OVR value being used as the override value. In this case, the diagnostic software (or diagnostic personnel) programs a register or the like providing the SW OVR select value as a logic 1. In addition, the SW OVR value is also programmed with an appropriate override value for use by the CN block 204.

The third row of Table 1 illustrates the case in which the software override value is used. When the SW OVR select value is programmed as a logic 1, then upon subsequent POR, after a short period of time (before TO) the SW OVR select value goes to logic 1, the priority output selector 308 asserts OSEL as logic 1 as shown in the third row of the table. In this case, the priority output selector 308 controls the override MUX 306 to select the SW OVR value as the SOVR value, in which SOVR = SW OVR is selected as the OUT value provided to the CN block 204. After the diagnostic process or procedure, the HW OVR select value, which may be configured as a hardware fuse, is programmed as a logic 1, and the HW OVR value, which may also be configured as a hardware fuse, is programmed with an appropriate value for use by the CN block 204.

The fourth row of Table 1 illustrates the case in which the hardware override value HW OVR is used. In this case, when the HW OVR select value is programmed as a logic 1, then upon subsequent POR, the priority output selector 308 asserts OSEL as logic 1, and selects the HW OVR value as the SOVR value provided to the output MUX 302. The output MUX 302 thus selects the SOVR = HW OVR value as the output value OUT to the CN block 204.

The fifth row of Table 1 illustrates the case in which the HW FMP value is reprogrammed as a logic 0 value on the metal layer of the semiconductor chip 100. In this case it has been determined that the ORG value is correctly provided in time so that substituting an override value is not needed. Thus, the priority output selector 308 is essentially hardwired to assert OSEL as logic 0 to select ORG upon start-up each time. Reprogramming the HW FMP value to 0 may require another tape-out, which may be done only when tape-out of the chip 100 is to be performed for other reasons.

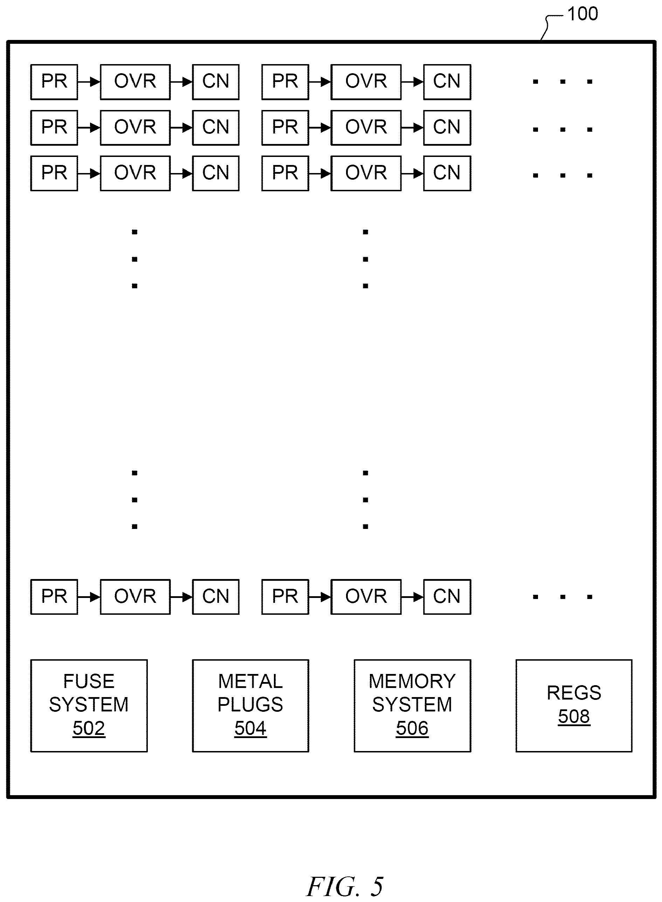

FIG. 5 is a simplified block diagram illustrating distribution of override circuits (OVR) across the semiconductor chip 100 inserted between pairs of PR blocks and CN blocks according to one embodiment. As previously described, each PR block represents any block, module or circuitry that provides an original signal or value intended to be provided to and used by the corresponding CN block. The chip 100 also includes a fuse system 502, metal plugs 504, a memory system 506, and a set of registers (REGS) 508. The fuse system 502 represents the fuse box 104, the fuse controller 106 and any other supporting circuitry for storing and distributing fuse values to various functional blocks distributed on the chip 100. The metal plugs 504 are typically programmed on one or more metal layers of the chip 100. The memory system 506 may include any on-chip memory devices and may further include memory controllers or the like for accessing external memory devices. The REGS 508 include any registers integrated on the chip 100 including general purpose registers or the like.

An OVR circuit is not needed on each and every interface of the original circuitry design. Instead, an OVR circuit may be inserted at "suspect" interfaces in which critical or otherwise important signals or values are being conveyed that might otherwise cause the chip 100 to lock-up or suspend operation or be stuck-in-reset at start-up such that the chip 100 is nonfunctional. Examples of such modules or circuitry may include, for example, testing blocks, clock generation or distribution blocks, reset circuitry blocks, security blocks, safety blocks, etc. In this manner, the distributed OVR circuitry allows override values to be provided when original values are not provided for any reason to allow the chip to at least enter debug operation in which diagnostic software may be executed to identify bugs or malfunctioning interfaces or the like and to patch or apply corrections or overrides or the like.

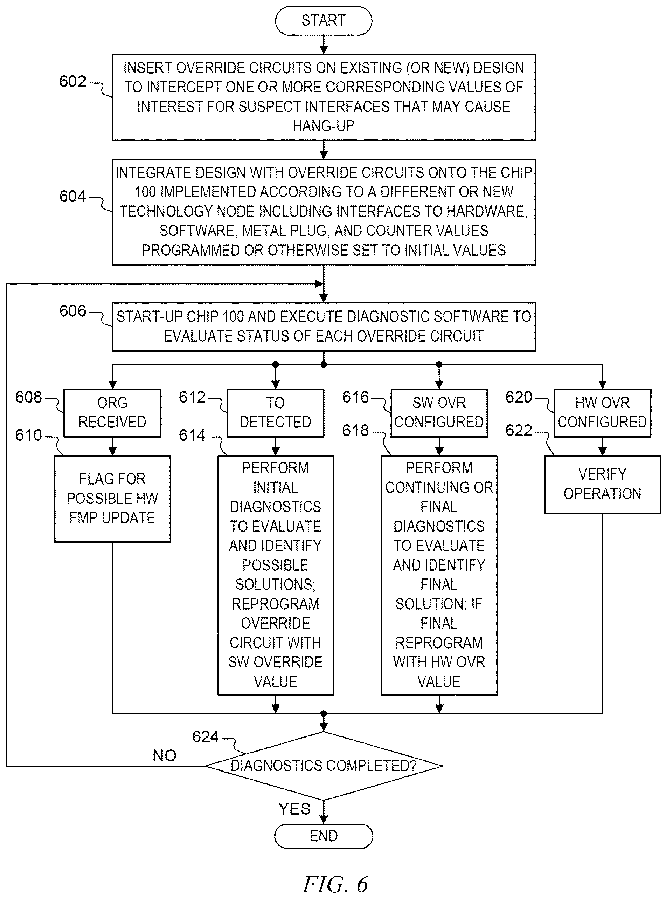

FIG. 6 is a flowchart diagram illustrating an override system and method according to one embodiment. At a first block 602, override circuits configured according to 200 or 300 are inserted into an existing design (or possibly even a new design to intercept corresponding values of interest for suspect interfaces that may cause hang-up when integrated onto a semiconductor chip. The suspect interfaces include interfaces between PR and CN blocks exchanging handshake signals or fuse values or multibit values or the like that are most likely to cause hang-up of the semiconductor chip upon start-up or even during operation. As previously noted, an OVR circuit is not needed on each and every interface, but instead only for those important or critical interfaces during start-up that might cause the chip to hang-up when malfunctioning.

At next block 604, the design with the override circuits is integrated onto the chip 100, which is implemented according to a different semiconductor process or a new technology node. Each override circuit is interfaces to corresponding hardware, software, metal plug, and counter values that are programmed or otherwise set to initial values. As described for override circuit 300, the HW OVR, SW OVR, HW OVR Select, and SW OVR Select values may initially be programmed to 0. The FMP OVR metal plug may be set to an initial value and HW FMP may be set to logic 1. In addition, the counter (e.g., counter 312 or timer 214) of each override circuit is programmed with an initial value to provide sufficient time for the ORG value in each case to be transferred between corresponding PR and CN blocks.

At next block 606, start-up of the chip 100 is performed with corresponding supporting circuitry and diagnostic software to evaluate operation of the chip 100 including evaluation of the status of each override circuit. The diagnostic software is configured to determine whether the original value ORG was transferred in time, whether a timeout of a counter 312 occurred, and whether the override circuit has been previously reprogrammed with SW OVR, HW OVR, or HW FMP values.

A block 608 represents each override circuit in which the ORG value provided by a PR block was received in time by a corresponding CN block according to normal operation. In this case, operation is correct, an override value is not needed, and the override circuit may left unmodified. Operation advances to a next block 610 in which the diagnostic software may set a flag or the like for possible HW FMP update to a logic 0 if desired.

A block 612 represents each override circuit in which a timeout (TO) was detected. In this case, ORG was not received in time such that the counter 312 asserted TO causing OT to be triggered. The priority output selector 308 thus selected FMP OVR as a default value and asserted OSEL to logic 1 so that FMP OVR was provided as the OUT value to the corresponding CN block. In this case operation advances to block 614 in which initial diagnostics may be performed to identify possible solutions that may be used to correct the malfunction. In addition, the corresponding SW OVR value may be programmed with an override value and SW OVR Select is programmed to logic 1 so that the priority output selector 308 outputs OSEL to logic 1 and controls the override MUX 306 to select the SW OVR value instead as the override value provided as the OUT value. This is intended as a temporary and revokable solution used for diagnostic purposes.

A block 616 represents each override circuit in which a SW OVR value has been previously programmed during diagnostic operations, such as during initial diagnostic functions described in block 614. In this case operation advances to block 618 in which continuing or final diagnostics may be performed to identify any additional or final solutions that may be used to correct the malfunction. It is noted that multiple software diagnostic iterations may be performed such that blocks 616 and 618 are performed multiple times until a final solution is determined. If a SW OVR value is identified as a suitable final value, then the HW OVR fuse of the override circuit may be reprogrammed with the same value in which the HW OVR Select value is also programmed to logic 1. Thus, the priority output selector 308 outputs OSEL to logic 1 and controls the override MUX 306 to select the HW OVR fuse value instead as the override value provided as the OUT value in subsequent iterations, which may be a final solution for the corresponding override circuit. It is possible, however, that the fuse box of the fuse system 502 is malfunctioning and not providing valid fuse values. In such a case the FMP OVR metal plug value may have to be used. In one embodiment, the corresponding counter 312 may be reprogrammed with a smaller value such that FMP OVR is selected as the override value as a final solution.

A block 620 represents each override circuit in which a suitable HW OVR fuse value has been previously programmed as a final value. In this case operation advances to block 622 in which the diagnostic software verifies whether operation is correct for subsequent start-ups.

After completion of blocks 610, 614, 618, and 622 for a given start-up iteration during diagnostic functions, operation advances to block 624 in which it is queried whether diagnostics have been completed for the chip 100. If not, such as when additional diagnostic iterations are needed, operation returns to block 606 in which the chip 100 is restarted for additional diagnostic operations and reprogramming of the override circuits. If diagnostics are completed, then operation is completed.

Although the present invention has been described in connection with several embodiments, the invention is not intended to be limited to the specific forms set forth herein. On the contrary, it is intended to cover such alternatives, modifications, and equivalents as can be reasonably included within the scope of the invention as defined by the appended claims. Anyone familiar with failure modes, effects, and diagnostic analysis (FMEDA) or similar risk analysis and an understanding of potential uncertainties in a new architecture or technology can define such override points. Variations of positive circuitry or negative circuitry may be used in various embodiments in which the present invention is not limited to specific circuitry polarities, device types or voltage or error levels or the like. Also, circuitry states, such as circuitry low and circuitry high may be reversed depending upon whether the pin or signal is implemented in positive or negative circuitry or the like. In some cases, the circuitry state may be programmable in which the circuitry state may be reversed for a given circuitry function.

The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

## Claims

1. An override circuit (200) for a semiconductor chip, comprising:
an override interface (210) configured to intercept an original value provided from a provider block (202) to a consumer block (204), wherein the override interface is configured to select between the original value (ORG) and a selected override value (SOVR) for providing an output value (OUT) to the consumer block;
a timer (214) configured to provide a timeout signal (TO) after a predetermined time period after a start-up time of the semiconductor chip; and
a priority override controller (212) having a default configuration for controlling the override interface to select the original value as the output value at the start-up time until the timeout signal is provided, and then to control the override interface to select a fixed metal hardware override value as the selected override value provided as the output value;
wherein the priority override controller is configurable to control the override interface to instead select the selected override value at start-up and to select at least one configurable override value as the selected override value.

2. The override circuit of claim 1, wherein the override interface comprises a multiplexer (302) having a first input receiving the original value, a second input receiving the selected override value, a select input (OSEL) receiving an output select signal from the priority override controller, and an output for providing the output value.

3. The override circuit of claim 1 or 2, wherein the timer comprises a counter (312) programmed with a count value indicative of a maximum time period.

4. The override circuit of any preceding claim, wherein the fixed metal hardware override value comprises a least one metal plug provided on a metal layer of the semiconductor chip.

5. The override circuit of any preceding claim, wherein the priority override controller comprises:
override select logic (306) that selects between the fixed metal hardware override value and the at least one configurable override value as the selected override value based on an override select signal; and
a priority output selector (308) having at least one first input for receiving at least one configurable select value, having a second input receiving an overtime signal indicative of the timeout signal, having a first output providing the override select signal and having a second output providing an output select signal for controlling the override interface.

6. The override circuit of claim 5, wherein the priority output selector has a default configuration when each of the at least one configurable select value has an initial non-select value for providing the override select signal so that the override select logic selects the fixed metal hardware override value as the selected override value, and for controlling the override interface to select the original value as the output value at the start-up time until the overtime signal is provided, and then to select the selected override value as the output value after the overtime signal is provided.

7. The override circuit of claim 5 or 6, further comprising a Boolean logic AND gate (310) having a first input receiving the timeout signal, having a second input receiving a hardware fixed metal plug value, and having an output providing the overtime signal.

8. The override circuit of any of claims 5 to 7, wherein the priority output selector has an override input receiving a hardware fixed metal plug value that causes the priority output selector to control the override interface to select the original value as the output value at start-up regardless of the at least one first input and the second input.

9. The override circuit of any of claims 5 to 8,
wherein the override select logic comprises a multiplexer (306) having a first input receiving a hardware override fuse value, a second input receiving a software override value, a third input receiving the fixed metal hardware override value, a select input receiving the override select signal, and an output providing the selected override value; and
wherein the priority output selector has a first input receiving a hardware override select value for selecting the hardware override fuse value as the selected override value when the hardware override select value is provided, a second input receiving a software override select value for selecting the software override value as the selected override value when the software override select value is provided, and a third input receiving the overtime signal for selecting the fixed metal hardware override value as the selected override value when the overtime signal is provided.

10. The override circuit of claim 9, wherein when the hardware override select value is provided, the priority output selector controls the override select logic to select the hardware override fuse value as the selected override value, wherein when the hardware override select value is not provided and the software override select value is provided, the priority output selector controls the override select logic to select the software override value as the selected override value, and wherein the priority output selector otherwise controls the override select logic to select the fixed metal hardware override value as the selected override value when the overtime signal is provided.

11. A method of circumventing semiconductor circuitry on an integrated circuit with unpredictable silicon behavior, comprising:
providing an override interface (210) between a provider block (202) and a consumer block (204) for selecting between the original value (ORG) provided by the provider block and a selected override value (SOVR) as an output value provided to the consumer block;
providing a timeout signal (TO) after a predetermined time period after a first start-up of the semiconductor circuitry;
initially controlling the override interface upon the first start-up to select the original value as the output value until the timeout signal is provided, and then to select a fixed metal hardware override value as the selected override value as the output value; and
when the original value is not provided before the timeout signal is provided after the first start-up, subsequently controlling the override interface to instead select the selected override value upon subsequent start-ups of the semiconductor circuitry and selecting at least one configurable override value as the selected override value.

12. The method of claim 11, further comprising programming the fixed metal hardware override value on a metal layer of the integrated circuit.

13. The method of claim 11 or 12, further comprising programming a fixed metal plug that modifies operation of the override interface to always select the original value upon subsequent start-ups.

14. The method of any of claims 11 to 13, further comprising:
programming a software override value; and
the selecting at least one configurable override value comprises selecting the software override value as the selected override value provided to the receive circuitry upon subsequent start-ups.

15. The method of claim 14, further comprising executing diagnostic software to identify solutions to correct behavior of the semiconductor circuitry.

## Patentansprüche

1. Übersteuerungsschaltung (200) für einen Halbleiterchip, umfassend:
eine Übersteuerungsschnittstelle (210), die dazu konfiguriert ist, einen von einem Anbieterblock (202) an einen Verbraucherblock (204) gelieferten Ursprungswert abzufangen,
wobei die Übersteuerungsschnittstelle dazu konfiguriert ist, zwischen dem Ursprungswert (ORG) und einem ausgewählten Übersteuerungswert (SOVR) auszuwählen, um dem Verbraucherblock einen Ausgabewert (OUT) bereitzustellen;
einen Zeitgeber (214), der dazu konfiguriert ist, ein Timeout-Signal (TO) nach einer vorbestimmten Zeitdauer nach einem Startzeitpunkt des Halbleiterchips bereitzustellen; und
einen Prioritätsübersteuerungscontroller (212) mit einer Standardkonfiguration zum Steuern der Übersteuerungsschnittstelle, um den Ursprungswert zum Startzeitpunkt als den Ausgabewert auszuwählen, bis das Timeout-Signal bereitgestellt wird, und dann die Übersteuerungsschnittstelle dahingehend zu steuern, einen festen Metall-Hardware-Übersteuerungswert als den ausgewählten Übersteuerungswert auszuwählen, der als der Ausgabewert bereitgestellt wird;
wobei der Prioritätsübersteuerungscontroller dazu konfigurierbar ist, die Übersteuerungsschnittstelle zu steuern, um stattdessen den ausgewählten Übersteuerungswert beim Start auszuwählen und mindestens einen konfigurierbaren Übersteuerungswert als den ausgewählten Übersteuerungswert auszuwählen.

2. Übersteuerungsschaltung nach Anspruch 1, wobei die Übersteuerungsschnittstelle einen Multiplexer (302) mit einem ersten Eingang, der den Ursprungswert empfängt, einem zweiten Eingang, der den ausgewählten Übersteuerungswert empfängt, einem Auswahleingang (OSEL), der ein Ausgangsauswahlsignal von dem Prioritätsübersteuerungscontroller empfängt, und einem Ausgang zum Bereitstellen des Ausgabewerts umfasst.

3. Übersteuerungsschaltung nach Anspruch 1 oder 2, wobei der Zeitgeber einen Zähler (312) umfasst, der mit einem Zählwert programmiert ist, welcher eine maximale Zeitdauer angibt.

4. Übersteuerungsschaltung nach einem vorhergehenden Anspruch, wobei der feste Metall-Hardware-Übersteuerungswert mindestens einen Metall-Plug umfasst, der auf einer Metallschicht des Halbleiterchips vorgesehen ist.

5. Übersteuerungsschaltung nach einem vorhergehenden Anspruch, wobei der Prioritätsübersteuerungscontroller Folgendes umfasst:
Übersteuerungsauswahllogik (306), die basierend auf einem Übersteuerungsauswahlsignal zwischen dem festen Metall-Hardware-Übersteuerungswert und dem mindestens einen konfigurierbaren Übersteuerungswert als den ausgewählten Übersteuerungswert auswählt; und
einen Prioritätsausgangswähler (308) mit mindestens einem ersten Eingang zum Empfangen mindestens eines konfigurierbaren Auswahlwerts, mit einem zweiten Eingang, der ein Overtime-Signal empfängt, das das Timeout-Signal angibt, mit einem ersten Ausgang, der das Übersteuerungsauswahlsignal bereitstellt, und mit einem zweiten Ausgang, der ein Ausgangsauswahlsignal zum Steuern der Übersteuerungsschnittstelle bereitstellt.

6. Übersteuerungsschaltung nach Anspruch 5, wobei der Prioritätsausgangswähler, wenn jeder des mindestens einen konfigurierbaren Auswahlwerts einen anfänglichen Nichtauswahlwert aufweist, eine Standardkonfiguration zum Bereitstellen des Übersteuerungsauswahlsignals, so dass die Übersteuerungsauswahllogik den festen Metall-Hardware-Übersteuerungswert als den ausgewählten Übersteuerungswert auswählt, und zum Steuern der Übersteuerungsschnittstelle zum Auswählen des Ursprungswerts als den Ausgabewert zum Startzeitpunkt, bis das Overtime-Signal bereitgestellt wird, und dann zum Auswählen des ausgewählten Übersteuerungswerts als den Ausgabewert nach Bereitstellung des Overtime-Signals aufweist.

7. Übersteuerungsschaltung nach Anspruch 5 oder 6, ferner umfassend ein boolesches Logik-UND-Gatter (310) mit einem ersten Eingang, der das Timeout-Signal empfängt, einem zweiten Eingang, der einen festen Hardware-Metall-Plug-Wert empfängt, und mit einem Ausgang, der das Overtime-Signal bereitstellt.

8. Übersteuerungsschaltung nach einem der Ansprüche 5 bis 7, wobei der Prioritätsausgangswähler einen Übersteuerungseingang aufweist, der einen festen Hardware-Metall-Plug-Wert empfängt, welcher bewirkt, dass der Prioritätsausgangswähler die Übersteuerungsschnittstelle so steuert, dass beim Start unabhängig von dem mindestens einen ersten Eingang und dem zweiten Eingang der Ursprungswert als der Ausgabewert ausgewählt wird.

9. Übersteuerungsschaltung nach einem der Ansprüche 5 bis 8,
wobei die Übersteuerungsauswahllogik einen Multiplexer (306) mit einem ersten Eingang, der einen Hardware-Übersteuerungs-Fuse-Wert empfängt, einem zweiten Eingang, der einen Software-Übersteuerungswert empfängt, einem dritten Eingang, der den festen Metall-Hardware-Übersteuerungswert empfängt, einem Auswahleingang, der das Übersteuerungsauswahlsignal empfängt, und einem Ausgang, der den ausgewählten Übersteuerungswert bereitstellt, umfasst; und
wobei der Prioritätsausgangswähler einen ersten Eingang, der einen Hardware-Übersteuerungsauswahlwert zum Auswählen des Hardware-Übersteuerungs-Fuse-Werts als den ausgewählten Übersteuerungswert empfängt, wenn der Hardware-Übersteuerungsauswahlwert bereitgestellt wird, einen zweiten Eingang, der einen Software-Übersteuerungsauswahlwert zum Auswählen des Software-Übersteuerungswerts als den ausgewählten Übersteuerungswert empfängt, wenn der Software-Übersteuerungsauswahlwert bereitgestellt wird, und einen dritten Eingang, der das Overtime-Signal zum Auswählen des festen Metall-Hardware-Übersteuerungswerts als den ausgewählten Übersteuerungswert empfängt, wenn das Overtime-Signal bereitgestellt wird, aufweist.

10. Übersteuerungsschaltung nach Anspruch 9, wobei, wenn der Hardware-Übersteuerungsauswahlwert bereitgestellt wird, der Prioritätsausgangswähler die Übersteuerungsauswahllogik dahingehend steuert, den Hardware-Übersteuerungs-Fuse-Wert als den ausgewählten Übersteuerungswert auszuwählen, wobei, wenn der Hardware-Übersteuerungsauswahlwert nicht bereitgestellt wird und der Software-Übersteuerungsauswahlwert bereitgestellt wird, der Prioritätsausgangswähler die Übersteuerungsauswahllogik dahingehend steuert, den Software-Übersteuerungswert als den ausgewählten Übersteuerungswert auszuwählen, und wobei der Prioritätsausgangswähler ansonsten die Übersteuerungsauswahllogik dahingehend steuert, den festen Metall-Hardware-Übersteuerungswert als den ausgewählten Übersteuerungswert auszuwählen, wenn das Overtime-Signal bereitgestellt wird.

11. Verfahren zur Umgehung einer Halbleiterschaltungsanordnung auf einer integrierten Schaltung mit unvorhersehbarem Siliciumverhalten, umfassend:
Bereitstellen einer Übersteuerungsschnittstelle (210) zwischen einem Anbieterblock (202) und einem Verbraucherblock (204) zum Auswählen zwischen dem durch den Anbieterblock bereitgestellten Ursprungswert (ORG) und einem ausgewählten Übersteuerungswert (SOVR) als Ausgabewert, der dem Verbraucherblock bereitgestellt wird;
Bereitstellen eines Timeout-Signals (TO) nach einer vorbestimmten Zeitdauer nach einem ersten Start der Halbleiterschaltungsanordnung;
anfängliches Steuern der Übersteuerungsschnittstelle beim ersten Start, um den Ursprungswert als den Ausgabewert auszuwählen, bis das Timeout-Signal bereitgestellt wird, und dann einen festen Metall-Hardware-Übersteuerungswert als den ausgewählten Übersteuerungswert als Ausgabewert auszuwählen; und
wenn der Ursprungswert nicht bereitgestellt wird, bevor das Timeout-Signal nach dem ersten Start bereitgestellt wird, anschließendes Steuern der Übersteuerungsschnittstelle, um stattdessen den ausgewählten Übersteuerungswert bei nachfolgenden Starts der Halbleiterschaltungsanordnung auszuwählen, und Auswählen mindestens eines konfigurierbaren Übersteuerungswerts als den ausgewählten Übersteuerungswert.

12. Verfahren nach Anspruch 11, ferner umfassend Programmieren des festen Metall-Hardware-Übersteuerungswerts auf einer Metallschicht der integrierten Schaltung.

13. Verfahren nach Anspruch 11 oder 12, ferner umfassend Programmieren eines festen Metall-Plugs, der den Betrieb der Übersteuerungsschnittstelle modifiziert, um bei nachfolgenden Starts immer den Ursprungswert auszuwählen.

14. Verfahren nach einem der Ansprüche 11 bis 13, ferner umfassend:
Programmieren eines Software-Übersteuerungswerts; und
wobei das Auswählen mindestens eines konfigurierbaren Übersteuerungswerts das Auswählen des Software-Übersteuerungswerts als den ausgewählten Übersteuerungswert, der der Empfangsschaltungsanordnung bei nachfolgenden Starts bereitgestellt wird, umfasst.

15. Verfahren nach Anspruch 14, ferner umfassend das Ausführen von Diagnosesoftware zum Identifizieren von Lösungen zur Korrektur des Verhaltens der Halbleiterschaltungsanordnung.

## Revendications

1. Circuit de surpassement (200) d'une puce à semiconducteur, comprenant :
une interface de surpassement (210) configurée pour intercepter une valeur d'origine fournie en provenance d'un bloc fournisseur (202) vers un bloc consommateur (204),
dans lequel l'interface de surpassement est configurée pour effectuer une sélection entre la valeur d'origine (ORG) et une valeur de surpassement sélectionnée (SOVR) pour fournir une valeur de sortie (OUT) au bloc consommateur ;
un temporisateur (214) configuré pour fournir un signal de temps d'arrêt (TO) après une période de temps prédéterminée après un instant de démarrage de la puce à semiconducteur ; et
un contrôleur de surpassement prioritaire (212) ayant une configuration par défaut pour commander l'interface de surpassement afin de sélectionner la valeur d'origine comme valeur de sortie à l'instant de démarrage jusqu'à ce que le signal de temps d'arrêt soit fourni, puis pour commander l'interface de surpassement afin de sélectionner une valeur de surpassement de matériel métallique fixe comme valeur de surpassement sélectionnée fournie comme valeur de sortie ;
dans lequel le contrôleur de surpassement prioritaire est configurable pour commander l'interface de surpassement pour sélectionner plutôt la valeur de surpassement sélectionnée au démarrage et pour sélectionner au moins une valeur de surpassement configurable comme valeur de surpassement sélectionnée.

2. Circuit de surpassement selon la revendication 1, dans lequel l'interface de surpassement comprend un multiplexeur (302) ayant une première entrée recevant la valeur originale, une deuxième entrée recevant la valeur de surpassement sélectionnée, une entrée de sélection (OSEL) recevant un signal de sélection de sortie en provenance du contrôleur de surpassement prioritaire, et une sortie pour fournir la valeur de sortie.

3. Circuit de surpassement selon la revendication 1 ou 2, dans lequel le temporisateur comprend un compteur (312) programmé avec une valeur de comptage indiquant une période de temps maximale.

4. Circuit de surpassement selon l'une quelconque des revendications précédentes, dans lequel la valeur de surpassement de matériel métallique fixe comprend au moins une fiche métallique prévue sur une couche métallique de la puce à semiconducteur.

5. Circuit de surpassement selon l'une quelconque des revendications précédentes, dans lequel le contrôleur de surpassement prioritaire comprend :
une logique de sélection de surpassement (306) qui sélectionne entre la valeur de surpassement de matériel métallique fixe et l'au moins une valeur de surpassement configurable comme valeur de surpassement sélectionnée sur la base d'un signal de sélection de surpassement ; et
un sélecteur de sortie prioritaire (308) ayant au moins une première entrée pour recevoir au moins une valeur de sélection configurable, ayant une deuxième entrée recevant un signal de dépassement indiquant le signal de temps d'arrêt, ayant une première sortie fournissant le signal de sélection de surpassement et ayant une deuxième sortie fournissant un signal de sélection de sortie destiné à commander l'interface de surpassement.

6. Circuit de surpassement selon la revendication 5, dans lequel le sélecteur de sortie prioritaire a une configuration par défaut lorsque chacune de l'au moins une valeur de sélection configurable a une valeur de non-sélection initiale pour fournir le signal de sélection de surpassement de sorte que la logique de sélection de surpassement sélectionne la valeur de surpassement de matériel métallique fixe comme valeur de surpassement sélectionnée, et pour commander l'interface de surpassement pour sélectionner la valeur d'origine comme valeur de sortie à l'instant de démarrage jusqu'à ce que le signal de dépassement soit fourni, puis pour sélectionner la valeur de surpassement sélectionnée comme valeur de sortie après que le signal de dépassement est fourni.

7. Circuit de surpassement selon la revendication 5 ou 6, comprenant en outre une porte logique booléenne ET (310) ayant une première entrée recevant le signal de temps d'arrêt, ayant une deuxième entrée recevant une valeur de fiche métallique fixe matérielle, et ayant une sortie fournissant le signal de dépassement.

8. Circuit de surpassement selon l'une quelconque des revendications 5 à 7, dans lequel le sélecteur de sortie prioritaire a une entrée de surpassement recevant une valeur de fiche métallique fixe matérielle qui amène le sélecteur de sortie prioritaire à commander l'interface de surpassement à sélectionner la valeur originale comme valeur de sortie au démarrage indépendamment de l'au moins une première entrée et de la deuxième entrée.

9. Circuit de surpassement selon l'une quelconque des revendications 5 à 8,
dans lequel la logique de sélection de surpassement comprend un multiplexeur (306) ayant une première entrée recevant une valeur de fusible de surpassement matérielle, une deuxième entrée recevant une valeur de surpassement logicielle, une troisième entrée recevant la valeur de surpassement matérielle métallique fixe, une entrée de sélection recevant le signal de sélection de surpassement, et une sortie fournissant la valeur de surpassement sélectionnée ; et
dans lequel le sélecteur de sortie prioritaire a une première entrée recevant une valeur de sélection de surpassement matérielle pour sélectionner la valeur de fusible de surpassement matérielle comme valeur de surpassement sélectionnée lorsque la valeur de sélection de surpassement matérielle est fournie, une deuxième entrée recevant une valeur de sélection de surpassement logicielle pour sélectionner la valeur de surpassement logicielle comme valeur de surpassement sélectionnée lorsque la valeur de sélection de surpassement logicielle est fournie, et une troisième entrée recevant le signal de dépassement pour sélectionner la valeur de surpassement de matériel métallique fixe comme valeur de surpassement sélectionnée lorsque le signal de dépassement est fourni.

10. Circuit de surpassement selon la revendication 9, dans lequel lorsque la valeur de sélection de surpassement matérielle est fournie, le sélecteur de sortie prioritaire commande la logique de sélection de surpassement pour sélectionner la valeur de fusible de surpassement matérielle comme valeur de surpassement sélectionnée, lorsque la valeur de sélection de surpassement matérielle n'est pas fournie et que la valeur de sélection de surpassement logicielle est fournie, le sélecteur de sortie prioritaire commandant la logique de sélection de surpassement pour sélectionner la valeur de surpassement logicielle comme valeur de surpassement sélectionnée, et le sélecteur de sortie prioritaire commandant autrement la logique de sélection de surpassement pour sélectionner la valeur de surpassement de matériel métallique fixe comme valeur de surpassement sélectionnée lorsque le signal de dépassement est fourni.

11. Procédé de contournement d'une circuiterie à semiconducteur sur un circuit intégré ayant un comportement de silicium imprévisible, comprenant :
la fourniture d'une interface de surpassement (210) entre un bloc fournisseur (202) et un bloc consommateur (204) pour sélectionner entre la valeur originale (ORG) fournie par le bloc fournisseur et une valeur de surpassement sélectionnée (SOVR) comme valeur de sortie fournie au bloc consommateur ;
la fourniture d'un signal de temps mort (TO) après une période de temps prédéterminé après un premier démarrage de la circuiterie à semiconducteur ;
la commande initiale de l'interface de surpassement lors du premier démarrage pour sélectionner la valeur d'origine comme valeur de sortie jusqu'à ce que le signal de temps mort soit fourni, puis pour sélectionner une valeur de surpassement de matériel métallique fixe comme valeur de surpassement sélectionnée comme valeur de sortie ; et
lorsque la valeur d'origine n'est pas fournie avant que le signal de temps mort ne soit fourni après le premier démarrage, la commande ultérieure de l'interface de surpassement pour sélectionner à la place la valeur de surpassement sélectionnée lors de démarrages suivants de la circuiterie à semiconducteur et la sélection d'au moins une valeur de surpassement configurable comme valeur de surpassement sélectionnée.

12. Procédé selon la revendication 11, comprenant en outre la programmation de la valeur de surpassement de matériel métallique fixe sur une couche métallique du circuit intégré.

13. Procédé selon la revendication 11 ou 12, comprenant en outre la programmation d'une fiche métallique fixe qui modifie un fonctionnement de l'interface de surpassement pour toujours sélectionner la valeur d'origine lors de démarrages ultérieurs.

14. Procédé selon quelconques des revendications 11 à 13, comprenant en outre :
la programmation d'une valeur de surpassement logicielle ; et
la sélection d'au moins une valeur de surpassement configurable comprend la sélection de la valeur de surpassement logicielle comme valeur de surpassement sélectionnée fournie à la circuiterie de réception lors de démarrages ultérieurs.

15. Procédé selon la revendication 14, comprenant en outre l'exécution d'un logiciel de diagnostic pour identifier des solutions pour corriger le comportement de la circuiterie à semiconducteur.
